**Europäisches Patentamt**

**European Patent Office**

**Office européen des brevets**

(19)

(11) Veröffentlichungsnummer : **0 653 081 B1**

(12) **EUROPÄISCHE PATENTSCHRIFT**

(45) Veröffentlichungstag der Patentschrift :
27.12.95 Patentblatt 95/52

(51) Int. Cl.$^6$ : **G06F 17/50**

(21) Anmeldenummer : **93915934.9**

(22) Anmeldetag : **16.07.93**

(86) Internationale Anmeldenummer :
**PCT/EP93/01875**

(87) Internationale Veröffentlichungsnummer :
**WO 94/03867 17.02.94 Gazette 94/05**

(54) **VERFAHREN ZUR SIMULATION WENIGSTENS EINES BAUELEMENTES, DESSEN KENNZEICHNENDE MERKMALE DURCH EINE MENGE VON WERTEPAAREN BESCHRIEBEN WERDEN, MITTELS EINES SIMULATORS AUF EINEM RECHNER**

(30) Priorität : **31.07.92 EP 92113107**

(43) Veröffentlichungstag der Anmeldung :
**17.05.95 Patentblatt 95/20**

(45) Bekanntmachung des Hinweises auf die
Patenterteilung :
**27.12.95 Patentblatt 95/52**

(84) Benannte Vertragsstaaten :
**DE FR GB**

(56) Entgegenhaltungen :
**US-A- 5 047 971
ANNALES DES TELECOMMUNICATIONS
MAI-JUNI 1992 Bd. 47, Nr. 5-6 Seiten 180 - 192
PEDEN ET AL 'modelisation non lineaire de
transistors mesfet'**

(56) Entgegenhaltungen :
**12TH EUROPEAN SOLID STATE CIRCUITS
CONFERENCE 1986 Seiten 211 - 213 RAUH 'a
table model for circuit simulation'
IEEE COMPUTER GRAPHICS AND APPLICA-
TIONS. Bd. 10, Nr. 1 , Januar 1990 , LOS
ALAMITOS CA US Seiten 10 - 17 FLETCHER
'automatic tension adjustment for interpolatory splines'**

(73) Patentinhaber : **SIEMENS
AKTIENGESELLSCHAFT
Wittelsbacherplatz 2
D-80333 München (DE)**

(72) Erfinder : **LANGE, Eberhard
Am Heckacker 15
D-90587 Obermichelbach (DE)**
Erfinder : **HAIBLE, Jürgen
An der Wied 2
D-91058 Erlangen-Tennenlohe (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 653 081 B1

## Beschreibung

Verfahren zur Simulation wenigstens eines Bauelementes, dessen kennzeichnende Merkmale durch eine Menge von Wertepaaren beschrieben werden, mittels eines Simulators auf einem Rechner

Die Erfindung betrifft ein Verfahren mit dem Bauelemente, wie z.B. elektronische Analogbauelemente auf einem rechnergestützten Simulator, schneller und exakter als bisher üblich simuliert werden können.

Die Simulation elektronischer Baugruppen hat sich in den den letzten Jahren zu einem wichtigen Thema entwickelt. Es wird immer wieder betont, daß die Simulation vor allem die Qualität der entwickelten Schaltungen verbessern kann und zu einer Steigerung der Produktivität führt [1] - [3]. Der Verbreitungsgrad der Simulation ist dennoch vor allem bei der Flachbaugruppenentwicklung relativ gering. Die Gründe dafür sind sowohl organisatorischer als auch technischer Art.

Eines der technischen Hemmnisse bei der Simulation - sowohl auf der digitalen als auch der analogen Seite - ist das Fehlen von geeigneten Modellen [3]. Während es bei der digitalen Simulation um die logische und zeitliche Beschreibung eines Bausteins mit einer entsprechenden Programmiersprache geht, handelt es sich bei Analogsimulation um die Umsetzung vorgegebener Meßkurven in mathematische Gleichungen, die mit Hilfe einer Modellierungssprache formuliert werden müssen. Obwohl derzeit auf dem Gebiet der analogen Modellierungssprachen kein Standard zu erkennen ist, bieten die meisten Simulatoren doch zumindest die Möglichkeit der Eingabe von mathematischen Funktionsgleichungen. Daher ist das Problem der Modellierung im wesentlichen auf die Gewinnung solcher Gleichungen reduziert.

Die Anforderungen an mathematische Gleichungen, die das physikalische Verhalten eines Bauteils beschreiben sollen, spalten sich in zwei Gruppen von Forderungen auf: Auf der einen Seite soll das physikalische Verhalten möglichst exakt beschrieben werden. Bei elektronischen Bauteilen liefert die Theorie oft für verschiedene Arbeitsbereiche auch unterschiedliche Beschreibungsfunktionen. Meistens ist es nicht möglich, ein Bauteil über den gesamten Arbeitsbereich auch mit nur einer Funktion zu beschreiben. Auf der anderen Seite sollen die Modelle möglichst effizient sein, der Simulator muß sie also schnell abarbeiten können. Je komplizierter die funktionalen Beschreibungen sind, desto langsamer läuft die Simulation ab. Gerade bei den für die Simulation besonders interessanten komplexen Schaltungen, spielt der Faktor "Simulationszeit" eine entscheidende Rolle.

Die der Erfindung zugrundeliegende Aufgabe besteht darin, ein Verfahren zur Simulation wenigstens eines Bauelementes anzugeben, das schneller und exakter arbeitet als bisher übliche Verfahren. Ein solches dem Oberbegriff des Anspruchs 1 entsprechendes Verfahren ist z.B. aus US-A-5 047 971 bekannt.

Diese Aufgabe wird gemäß dem kennzeichnenden Teil des Patentanspruches 1 gelöst.

Alle übrigen Weiterbildungen der Erfindung ergeben sich aus den Unteransprüchen.

Es werden zunächst die für die Modellierung relevanten mathematischen Grundlagen beschrieben. Anschließend wird das von uns erfundene Verfahren vorgestellt. Im Anschluß wird anhand eines praktischen Beispiels (Strombegrenzerdiode F452) die Leistungsfähigkeit demonstriert.

## Mathematische Grundlagen

### Voraussetzungen

Wir gehen von der Tatsache aus, daß das physikalische Verhalten eines Bauteils in Form einer Funktion f graphisch vorgegeben ist. Aus dem Funktionsgraphen lassen sich Datenpunkte $(x_i, y_i)$, i = 1,...,n mit $n \in N$ und $y_i = f(x_i)$ entnehmen. Das Ziel ist es, diese Datenpunkte und den dazwischenliegenden Kurvenverlauf der Funktion f durch mathematische Funktionen möglichst gut zu beschreiben.

Sei $n \in N$, M := {1,2,...,n}. Seien a,b $\in R$ mit a<b. Sei $(x_i)_{i \in M}$ eine reelle, aufsteigende Familie mit $x_1 = a$, $x_n = b$, sei $(y_i)_{i \in M}$ eine reelle Familie. Dann versteht man unter der Partitionierung des Intervalls I:=[a,b] die Menge der Teilintervalle $I_i$, $i \in M \backslash \{n\}$, wo $I_i := [x_i, x_{i+1}]$. Die Familie $(x_i, y_i)_{i \in M}$ wird auch als Menge der Datenpunkte D bezeichnet.

Sei $m \in N$. Dann bezeichnet $C^m[I]$ die Menge der auf I m-mal stetig-differenzierbaren Funktionen.

### Splines

Sei I:= [a,b] ein Intervall mit einer zugehörigen Partitionierung. Unter einem Spline vom Grad m ($m \in N$) versteht man eine auf I definierte Funktion s: I → R , x ↦ s(x) mit den folgenden Zusatzeigenschaften:

(i) $s \in C^{m-1}[I]$

(ii) Auf jedem Teilintervall $I_i$ ist s ein Polynom höchstens vom Grad m.

Die Eigenschaft (i) bedeutet, daß ein Spline vom Grad m (m-1)-mal stetig differenzierbar ist.

Ein Spline heißt kubischer Spline, wenn sein Grad m=3 ist. Ein kubischer Spline ist damit 2-mal stetig differenzierbar und ist auf jedem Teilintervall $I_i$ ein Polynom höchstens dritten Grades.

Ein Spline heißt interpolierender Spline zur Partitionierung $I_i$ und zur Menge der Datenpunkte D, wenn gilt:

$$s(x_i) = y_i \text{ für } i = 1,...,n \quad (2.1)$$

Kubische interpolierende Splines werden im folgenden einfach Splines genannt.

## Existenz und Eindeutigkeit der Splines

Sei I:= [a,b] wieder ein Intervall mit einer zugehörigen Partitionierung. Sei $f \in C^2[I]$, s: I → R Spline. Erfüllt s eine der nachfolgenden Bedingungen, so ist s eindeutig bestimmt:

$$(i) \qquad s''(a) = s''(b) = 0$$
$$(ii) \qquad s'(a) = f'(a) \text{ und } s'(b) = f'(b) \quad (2.2)$$

Im Fall (i) wird s auch als natürlicher Spline bezeichnet. Im Fall (ii) wird vorausgesetzt, daß die Ableitungen der Funktion f in den Randpunkten a,b bekannt sind.

## Praktische Konsequenzen der Interpolation mit Splines

Da $s \in C^2[I]$, folgt insbesondere, daß in den Datenpunkten gilt:

$$s(x_i^+) = s(x_i^-) = y_i \text{ für } i = 1,...,n \quad (2.3)$$
$$s'(x_i^+) = s'(x_i^-) \text{ für } i = 2,...,n-1 \quad (2.4)$$

sowie

$$s''(x_i^+) = s''(x_i^-) \text{ für } i = 2,...,n-1 \quad (2.5)$$

Dabei bezeichnet $s(x_i^+)$ den Funktionswert des Splines, der durch das repräsentierende Polynom dritter Ordnung im Teilintervall $[x_i, x_{i+1}]$ an der Stelle $x_i$ gegeben ist. Analog bezeichnet $s(x_i^-)$ den Funktionswert des Polynoms im Teilintervall $[x_{i-1}, x_i]$ an der Stelle $x_i$.

Die Datenpunkte $(x_i, y_i)_{i \in M}$ werden also durch eine 2-mal stetig differenzierbare Funktion interpoliert. Die Datenpunkte liegen explizit auf dem Funktionsgraphen. Insbesondere erhält man eine glatte Kurve, die keine "Sprünge" (Unstetigkeitsstellen) oder "Knicke" (nicht-differenzierbare Stellen) besitzt.

Die zweite Ableitung $s''(x)$ des Splines ist auf jedem Teilintervall ein lineares Polynom.

## Minimaleigenschaft der Splines

Die Menge der auf dem Intervall I stetig-differenzierbaren Funktionen, deren zweite Ableitung fast überall existiert und quadratisch Lebesgue-integrabel ist, wird mit $H^2[I]$ bezeichnet. Damit läßt sich für Funktionen $f \in H^2[I]$ die Halbnorm

$$\|f\| := \sqrt{\int_a^b |f''(x)|^2 \, dx}$$

definieren. $|f''(x)|$ ist ein Maß für das Krümmungsverhalten von f an der Stelle x. Die Krümmung im quadratischen Mittel ist also gerade durch $\|f\|$ gegeben.

Die Minimaleigenschaft der Splines besagt nun, daß der natürliche Spline s von allen Funktionen $f \in C^2[I]$, für die $f(x_i) = y_i$ für i=1,....,n gilt, den kleinstmöglichen Wert für die Krümmung im quadratischen Mittel liefert. In diesem Sinne ist der Spline also die glatteste interpolierende Funktion für die gegebenen Datenpunkte.

## Konvergenzeigenschaft der Splines

Splines konvergieren gegen die Funktion, die sie interpolieren, wenn man die Partitionierungen $I_i$ immer feiner wählt. Dies gilt im Gegensatz zur Interpolation mit gewöhnlichen Polynomen. Bei der Interpolation mit Splines ist man also nicht aus prinzipiellen Gründen in der erreichbaren Genauigkeit der Interpolation beschränkt.

## Spline-Algorithmen als Matrixgleichungen

Die systematische Auswertung der in den Unterkapiteln 2.2 und 2.3 genannten Bedingungen führen auf Matrixgleichungen, die mit Hilfe von Algorithmen für lineare Gleichungssysteme gelöst werden können (genaueres siehe [4]).

## Bogenlänge von Splines

Die Bogenlänge einer beliebigen Funktion, also insbesondere des Splines s ist durch

$$b(s) = \int_a^b \sqrt{1+(s'(x))^2}\, dx \qquad (2.6)$$

gegeben. Dieses Integral läßt sich zwar prinzipiell explizit berechnen [6], dies ist jedoch recht mühsam. Bei der konkreten Berechnung greift man daher auf numerische Verfahren (siehe zum Beispiel [4]) zurück.

## Beschreibung der Algorithmen

### Voraussetzungen

Die Datenpunkte werden in der Praxis zumeist einer auf einem Datenblatt vorgegebenen Funktionskurve entnommen. Solche physikalischen Kurven enthalten oft zumindest optisch "Knicke", die in erster Näherung als nicht-differenzierbare Punkte angesehen werden können. Dies ist zum Beispiel bei der Kennlinie einer Diode (Durchbruchsspannung) der Fall. Deshalb ist in den hier beschriebenen Algorithmen die Möglichkeit von nicht-differenzierbaren Punkten explizit vorgesehen. Weitere markante Punkte, die man aus einem Datenblatt entnehmen kann, sind relative Maxima und Minima. Die Möglichkeit, bestimmte Punkte explizit als Extrema zu definieren, ist in unseren Algorithmen ebenfalls vorgesehen.

### Geschlossener Spline-Algorithmus

Die Interpolation mit Splines läßt sich auch ohne die Verwendung von Matrizen als Algorithmus formulieren. In diesem Unterkapitel wird das Kernstück unserer Algorithmen als matrixunabhängige natürliche Spline-Interpolation formuliert. Der Algorithmus ist autonom, insbesondere werden keine Matrizen eingesetzt.

Der Spline im Teilintervall $I_i$ läßt sich schreiben als

$$s(x) = a_{i,3}\cdot(x - x_i)^3 + a_{i,2}\cdot(x - x_i)^2 + a_{i,1}\cdot(x - x_i) + a_{i,0} \qquad (3.1)$$

wo $i \in M\backslash\{n\}$ mit $n>1$.

Ziel des Algorithmus ist also die Bestimmung der Koeffizienten $a_{i,0}$, $a_{i,1}$, $a_{i,2}$ und $a_{i,3}$ in jedem Teilintervall. Für $n < 2$ (Teilintervall mit weniger als zwei Punkten) ist der Algorithmus nicht anwendbar und wird mit einem Fehler abgebrochen. Ebenso führen Datenpunkte, deren Ordinaten nicht in aufsteigender Reihenfolge angeordnet sind ($x_j \geq x_{j+1}$), zu einem Fehler und Abbruch.

Durch Differenzieren von (3.1) folgt:

$$s'(x) = 3\cdot a_{i,3}\cdot(x - x_i)^2 + 2\cdot a_{i,2}\cdot(x - x_i) + a_{i,1}$$
$$s''(x) = 6\cdot a_{i,3}\cdot(x - x_i) + 2\cdot a_{i,2} \qquad (3.2)$$

Aus (3.1) und (3.2) folgt:

$$s(x_i) = a_{i,0}$$
$$s'(x_i) = a_{i,1}$$
$$s''(x_i) = 2\cdot a_{i,2}$$
$$s''(x_{i+1}) = 6\cdot a_{i,3}\cdot(x_{i+1} - x_i) + 2\cdot a_{i,2}$$

Auflösen dieser Gleichungen nach den Koeffizienten ergibt $\forall\, i \in M\backslash\{n\}$:

$$a_{i,0} = y_i$$
$$a_{i,1} = s'(x_i)$$
$$a_{i,2} = \frac{1}{2}\cdot s''(x_i)$$
$$a_{i,3} = \frac{s''(x_{i+1}) - s''(x_i)}{6\cdot(x_{i+1} - x_i)} \qquad (3.3)$$

Die ersten und zweiten Ableitungen $s'(x_i)$ und $s''(x_i)$ können mit einem iterativen Verfahren berechnet werden. Dazu werden zunächst Differenzen $\Delta_x^i$, $\Delta_y^i$ und Differenzenquotienten $\Delta^i$ definiert:

$$\Delta_x^i := x_{i+1} - x_i$$
$$\Delta_y^i := y_{i+1} - y_i$$

$$\Delta^i := \frac{\Delta^i_y}{\Delta^i_x} \quad (3.4)$$

Mit Hilfe der Gleichungen (3.1) und (3.2) erhält man:

$$s(x_{i+1}) = a_{i,3}\cdot(\Delta^i_x)^3 + a_{i,2}\cdot(\Delta^i_x)^2 + a_{i,1}\cdot\Delta^i_x + a_{i,0}$$

$$s'(x_{i+1}) = 3\cdot a_{i,3}\cdot(\Delta^i_x)^2 + 2\cdot a_{i,2}\cdot\Delta^i_x + a_{i,1}$$

$$s''(x_{i+1}) = 6\cdot a_{i,3}\cdot\Delta^i_x + 2\cdot a_{i,2} \quad (3.5)$$

Hier können die Ergebnisse für $a_{i,2}$, $a_{i,1}$ und $a_{i,0}$ aus den Gleichungen (3.3) eingesetzt werden:

$$s(x_{i+1}) = a_{i,3}\cdot(\Delta^i_x)^3 + \frac{1}{2} s''(x_i)\cdot(\Delta^i_x)^2 + s'(x_i)\cdot\Delta^i_x + y_i \quad (3.6)$$

$$s'(x_{i+1}) = 3\cdot a_{i,3}\cdot(\Delta^i_x)^2 + s''(x_i)\cdot\Delta^i_x + s'(x_i)$$

$$s''(x_{i+1}) = 6\cdot a_{i,3}\cdot(\Delta^i_x) + s''(x_i) \quad (3.7)$$

Mit $s(x_{i,1}) = y_{i+1}$ erhält man aus (3.6):

$$\Delta^i_y = a_{i,3}\cdot(\Delta^i_x)^3 + \frac{1}{2} s''(x_i)\cdot(\Delta^i_x)^2 + s'(x_i)\cdot(\Delta^i_x)$$

Auflösen nach $a_{i,3}$ ergibt nun

$$a_{i,3} = \frac{\Delta^i_y}{(\Delta^i_x)^3} - \frac{s''(x_i)}{2\cdot\Delta^i_x} - \frac{s'(x_i)}{(\Delta^i_x)^2} \quad (3.8)$$

Setzt man Gleichung (3.8) in die Gleichungen (3.7) ein, so erhält man Iterationsgleichungen für die ersten und zweiten Ableitungen $s'(x_i)$ und $s''(x_i)$:

$$s'(x_{i+1}) = 3\cdot\Delta^i - \frac{1}{2} s''(x_i)\cdot\Delta^i_x - 2\cdot s'(x_i)$$

$$s''(x_{i+1}) = 6\frac{\Delta^i}{\Delta^i_x} - 2\cdot s''(x_i) - 6\frac{s'(x_i)}{\Delta^i_x} \quad (3.9)$$

Mit Hilfe der Gleichungen (3.9) können, sofern die Werte für $s'(x_1)$ und $s''(x_1)$ bekannt sind, sämtliche ersten und zweiten Ableitungen in den Stützstellen und damit über die Gleichungen (3.3) auch sämtliche Koeffizienten des Splines berechnet werden.

Im Fall eines natürlichen Splines (siehe Gleichung (2.2)) sind nicht $s'(x_1)$ und $s''(x_1)$ vorgegeben, sondern $s''(x_1)=0$ und $s''(x_n)=0$. Die Iterationsgleichungen (3.9) lassen sich schreiben als

$$s'(x_i) = c_i\cdot s'(x_1) + e_i$$

$$s''(x_i) = \tilde{c}_i\cdot s'(x_1) + \tilde{e}_i \quad (3.10)$$

mit

$$c_{i+1} = -\frac{1}{2}\Delta^i_x\cdot\tilde{c}_i - 2\cdot c_i$$

$$e_{i+1} = 3\cdot\Delta^i - \frac{1}{2}\Delta^i_x\cdot\tilde{e}_i - 2\cdot e_i \quad (3.11)$$

$$\tilde{c}_{i+1} = -2\cdot\tilde{c}_i - 6\frac{c_i}{\Delta^i_x}$$

$$\tilde{e}_{i+1} = 6\frac{\Delta^i}{\Delta^i_x} - 2\cdot\tilde{e}_i - 6\frac{e_i}{\Delta^i_x}$$

$$(3.12)$$

Mit den Anfangsbedingungen (natürlicher Spline)

$$c_1 = 1$$

$$e_1 = 0$$

$$\tilde{c}_1 = 0$$

$$\tilde{e}_1 = s''(x_1) = 0 \quad (3.13)$$

5

läßt sich die Äquivalenz der Gleichungen (3.10) bis (3.13) mit (3.9) durch unvollständige Induktion nach i beweisen (siehe Anhang B).

Für i = n ergibt sich aus Gleichung (3.10), daß

$$s''(x_n) = \check{c}_n \cdot s'(x_1) + \check{e}_n$$

Auflösen nach $s'(x_1)$ ergibt für den Fall eines natürlichen Splines

$$s'(x_1) = -\frac{\check{e}_n}{\check{c}_n} \qquad (3.14)$$

Der Fall, daß $\check{c}_n = 0$, ist dabei ausgeschlossen, da $c_i$ und $\check{c}_i$ jeweils paarweise streng positiv oder streng negativ (abwechselnd mit i) sind. Die sukzessive Anwendung der Gleichungen (3.4), (3.13), (3.12), (3.14), (3.9) und (3.3) stellen einen geschlossenen Algorithmus zur Berechung der Koeffizienten $a_{i,0}$, $a_{i,1}$, $a_{i,2}$ und $a_{i,3}$ des Splines in jedem Teilintervall $I_i$ ($i \in M\backslash\{n\}$) dar.

## Behandlung nicht-differenzierbarer Punkte

Soll die Funktionskurve explizit nicht-differenzierbare Punkte enthalten, so läßt sich dies sehr einfach durch die Aufteilung der Menge der Datenpunkte $D = \{(x_i, y_i), i \in M\}$ in mehrere Untermengen erreichen: Sei $x_j$ mit $j \in M$ eine nicht-differenzierbare Stelle, so definiert man Untermengen $M_1 := \{1,...,j\}$ und $M_2 := \{j,...,n\}$ der Menge M und wendet den in Kapitel 3.2 beschriebenen Algorithmus separat auf die Mengen der Datenpunkte $D_1 := \{(x_i, y_i), i \in M_1\}$ und $D_2 := \{(x_i, y_i), i \in M_2\}$ an.

Sei nun $s_1$ der (natürliche) Spline zur Menge der Datenpunkte $D_1$ und $s_2$ der (natürliche) Spline zur Menge der Datenpunkte $D_2$. Dann gilt nach Gleichung (2.1) insbesondere, daß

$$s_1(x_j) = s_2(x_j) = y_j$$

Der durch die beiden Splines beschriebene Funktion ist also nach wie vor auf dem gesamten Intervall, insbesondere an der Stelle $x_j$ stetig.

Im allgemeinen wird aber

$$s_1'(x_j) \neq s_2'(x_j)$$

sein, das heißt die Funktion ist an der Stelle $x_j$ nicht mehr differenzierbar. Der Kurvenverlauf weist also einen "Knick" auf.

Liegen mehrere nicht-differenzierbare Punkte vor, so kann analog eine weitere Aufteilung in Untermengen vorgenommen werden.

## Behandlung von Extremalpunkten

Beim Auftreten von explizit vorgegebenen Extremalpunkten wird wie im Kapitel 3.4 eine Aufteilung der Menge der Datenpunkte in Untermengen vorgenommen. Die Bedingung für einen Extremalpunkt an der Stelle $x_j$, $j \in M$ lautet

$$s'(x_j) = 0 \quad (3.15)$$

Gleichung (3.15) stellt eine zusätzliche Forderung an den (natürlichen) Spline dar, er ist daher überbestimmt. Im folgenden wird beschrieben, in welcher Weise andere Anforderungen an den Spline zur Erfüllung von Gleichung (3.15) fallen gelassen werden und in welcher Weise der in Kapitel 3.3 beschriebene Algorithmus modifiziert wird.

Sei $U = \{(x_i, y_i), i \in \tilde{M}\}$, $\tilde{M} = \{j_1,.....,j_2\}$ mit $j_1, j_2 \in N$ eine Untermenge von D. Ist $j_2 - j_1 + 1 < 3$ (Teilintervall mit weniger als 3 Punkten), so wird der Algorithmus mit einem Fehler abgebrochen. Dann wird zunächst eine Neunumerierung der Indizes vorgenommen ($i \rightarrow i - j_1 + 1$), sodaß der Algorithmus auf eine Menge von Datenpunkten $(x_i, y_i)$, $i = 1,...,n$ wo $n = j_2 - j_1 + 1$ angewandt werden kann.

Es sind nun drei Fälle zu unterscheiden: (1) $x_1$ ist ein Extremalpunkt (2) $x_n$ ist ein Extremalpunkt und (3) $x_1$ und $x_n$ sind beide Extremalpunkte.

**Fall (1):** Ist $x_1$ ein Extremalpunkt, so lautet Gleichung (2.2) sinngemäß

$$s'(x_1) = 0 \text{ und } s''(x_n) = 0 \quad (3.16)$$

Der Spline ist mit Hilfe von Gleichung (3.16) eindeutig bestimmt. Allerdings erhält man jetzt keinen natürlichen Spline mehr, da die Bedingung $s''(x_1) = 0$ aufgegeben wurde. Der in Kapitel 3.3 beschriebene Algorithmus muß wie folgt modifiziert werden: Die Iterationsgleichungen (3.9) lassen sich schreiben als

$$s'(x_i) = c_i \cdot s''(x_1) + e_i$$
$$s''(x_i) = \check{c}_i \cdot s''(x_1) + \check{e}_i \qquad\qquad (3.17)$$

Die Gleichungen (3.10) werden also durch (3.17) substituiert. Dabei bestehen für $c_i$, $\check{c}_i$, $e_i$ und $\check{e}_i$ weiterhin die Interationsgleichungen (3.11) und (3.12). Für die Anfangsbedingungen ergibt sich aber nun im Vergleich mit den Gleichungen (3.9) und (3.17):

$$c_1 = 0$$
$$e_1 = s'(x_1) = 0$$
$$\check{c}_1 = 1$$
$$\check{e}_1 = 0 \qquad (3.18)$$

Die Gleichungen (3.13) werden also durch (3.18) substituiert. Für $i = n$ ergibt sich hier aus Gleichung (3.17), daß

$$s''(x_n) = \check{c}_n \cdot s''(x_1) + \check{e}_n$$

Das bedeutet, daß nun analog zu Gleichung (3.14)

$$s''(x_1) = -\frac{\check{e}_n}{\check{c}_n} \qquad\qquad (3.19)$$

gilt.

**Fall (2):** Ist $x_n$ ein Extremalpunkt, so lautet Gleichung (2.2) sinngemäß

$$s''(x_1) = 0 \text{ und } s'(x_n) = 0 \qquad (3.20)$$

Der Spline ist mit Hilfe von Gleichung (3.20) wiederum eindeutig bestimmt. Auch hier erhält man keinen natürlichen Spline. Der in Kapitel 3.3 beschriebene Algorithmus muß wie folgt modifiziert werden: Für $i = n$ ergibt sich aus Gleichung (3.10), daß

$$s'(x_n) = c_n \cdot s'(x_1) + e_n$$

Auflösen nach $s'(x_1)$ ergibt mit Gleichung (3.20):

$$s'(x_1) = -\frac{e_n}{c_n} \qquad (3.21)$$

Gleichung (3.14) wird also durch (3.21) ersetzt.

**Fall (3):** Sind $x_1$ und $x_n$ Extremalpunkte, so fordert man analog zu Gleichung (2.2), daß

$$s'(x_1) = 0 \text{ und } s'(x_n) = 0 \qquad (3.22)$$

Wie in Fall (1) gelten auch hier die modifizierten Anfangsbedingungen (3.18). Für $i = n$ erhält man aus Gleichung (3.17):

$$s'(x_n) = c_n \cdot s''(x_1) + e_n$$

Nach Gleichung (3.22) berechnet sich $s''(x_1)$ zu

$$s''(x_1) = -\frac{e_n}{c_n} \qquad (3.23)$$

Gleichung (3.14) wird also durch (3.23) ersetzt.

**Ablauf der Algorithmen**

Zunächst wird die in den Kapiteln 3.3 und 3.4 beschriebene Aufteilung der Menge der Datenpunkte in Untermengen vorgenommen, sofern nicht-differenzierbare beziehungsweise Extremalpunkte vorliegen. Dabei werden auch Kombinationen berücksichtigt, zum Beispiel kann eine Untermenge $U = \{(x_i,y_i),\ i \in \tilde{M}\}$, $\tilde{M} = \{j_1,...,j_2\}$ mit $j_1, j_2 \in N$ mit dem nicht-differenzierbaren Punkt $x_{j_1}$ beginnen und mit dem Extremalpunkt $x_{j_2}$ enden. Analoges gilt für alle weiteren möglichen Kombinationen.

In einem zweiten Schritt werden dann die in den Kapiteln 3.3 und 3.4 beschriebenen Algorithmen auf die Untermengen der Datenpunkte angewandt. Dazu wird für jede Untermenge die in Kapitel 3.4 erläuterte Neunumerierung der Indizes vorgenommen, sodaß die Algorithmen jeweils für Datenpunkte $(x_i,y_i)$ mit $i = 1,...,n$ wo $n = j_2 - j_1 + 1$ durchgeführt werden.

Tritt während des Ablaufs ein Fehler auf, so wird der Algorithmus abgebrochen.

**Sonderfall: n=2**

In diesem Unterkapitel soll noch nachgewiesen werden, daß der in Kapitel 3.3 beschriebene Algorithmus auch im Fall $n = 2$ (das heißt, wenn nur 2 Datenpunkte für die Interpolation zur Verfügung stehen) vernünftige Resultate liefert.

In diesem Fall liefert der Algorithmus, daß $s'(x_1) = \Delta^1$ und somit $s'(x_2) = \Delta^1$. Für die Koeffizienten folgt: $a_{i,0} = y_1$, $a_{i,1} = \Delta^1$, $a_{i,2} = a_{i,3} = 0$. Der Spline lautet damit: $s(x) = \Delta^1 \cdot (x-x_1) + y_1$. Man erhält also erwartungsgemäß eine Gerade, die die beiden Datenpunkte $(x_1,y_1)$ und $(x_2,y_2)$ verbindet.

**Berechnung von Schrittweiten**

Der Simulator kann zusätzlich zur Beschreibung des Bauteils durch mathematische Gleichungen noch Angaben darüber verlangen, mit welcher Genauigkeit (Schrittweite) diese Gleichungen in den entsprechenden Teilintervallen ausgeführt werden sollen. Dies ist zum Beispiel beim Analogsimulator SABER der Fall. Eine hohe Genauigkeit (geringe Schrittweite) kann erforderlich sein, wenn

- die Funktionskurve von dem linearen Verhalten einer Geraden abweicht,
- oder ein sich schnell ändernder Bereich der Kurve (große Steilheit) genauer betrachtet werden soll.

Im ersten Fall ist die Krümmung des Splines $s''(x)$ ein Maß für die Genauigkeit: Große Krümmung erfordert hohe Genauigkeit. Als Maßzahl kann das Maximum der Krümmung in einem vorgegebenen Intervall verwendet werden. Dieses läßt sich leicht ermitteln, da die zweite Ableitung $s''(x)$ ein lineares Polynom ist (es genügt, die Randwerte im jeweiligen Intervall zu betrachten).

Im zweiten Fall kann entweder auf die Steigung $s'(x)$ oder besser auf die in Gleichung (2.6) beschriebene Bogenlänge $b(s)$ des Splines zurückgegriffen werden. $b(s)$ kann direkt als Maßzahl verwendet werden, das Maximum der Steigung muß aus den Randwerten und dem möglicherweise vorhandenen relativen Extrema (Bestimmungsgleichung $s'(x_E)=0$) bestimmt werden.

Im folgenden wird die Erfindung anhand von Figuren und Ausführungsbeispielen weiter erläutert.

**Anwendungsbeispiel**

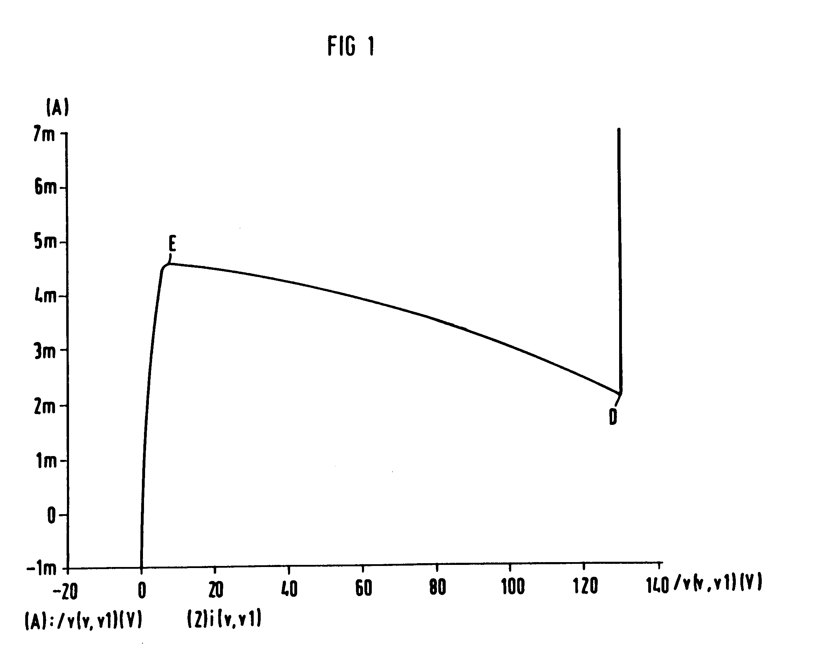

In diesem Unterkapitel soll die Anwendung unseres Verfahrens an einem konkreten Beispiel erprobt werden. Dafür wurde eine Strombegrenzerdiode vom Typ F452 ausgewählt. Die Kennlinie der Diode enthält sowohl einen Extremalpunkt als auch einen nicht-differenzierbaren Punkt. Vom Vertreiber war ein Datenblatt verfügbar, aus dem Datenpunkte der Kennlinie entnommen werden konnten. Tabelle 1 zeigt eine Liste der Datenpunkte, wie sie dem Verfahren als Eingabe zur Verfügung gestellt wurden. Es wurde mit einem Analogsimulator simuliert (DC Transfer Analyse). Figur 1 zeigt die Kennlinie der Diode, wie sie sich als Ergebnis der Simulation ergibt.

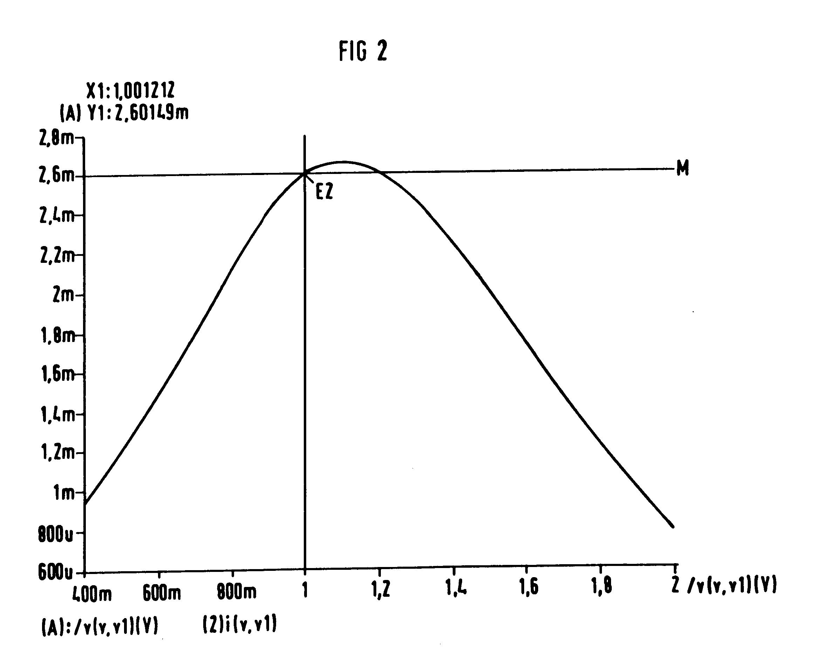

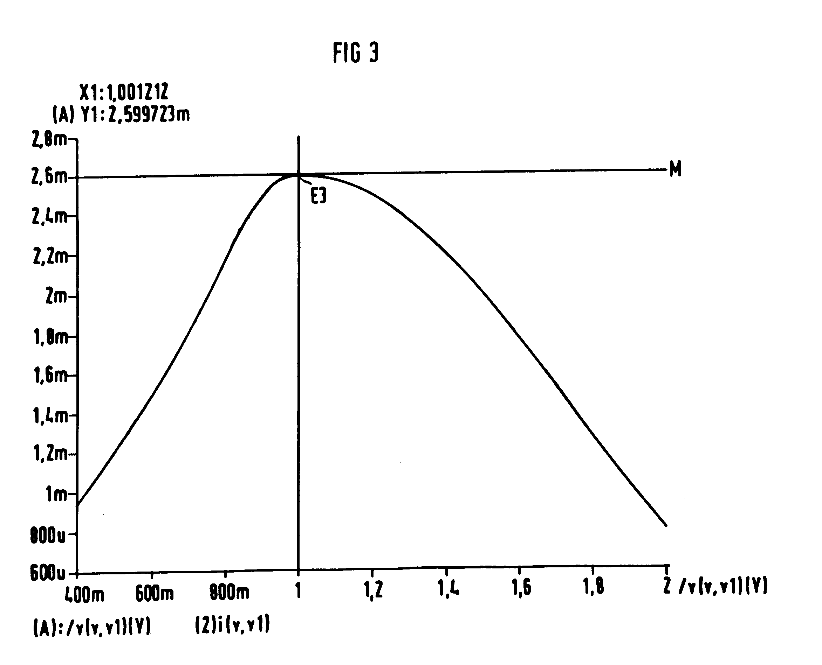

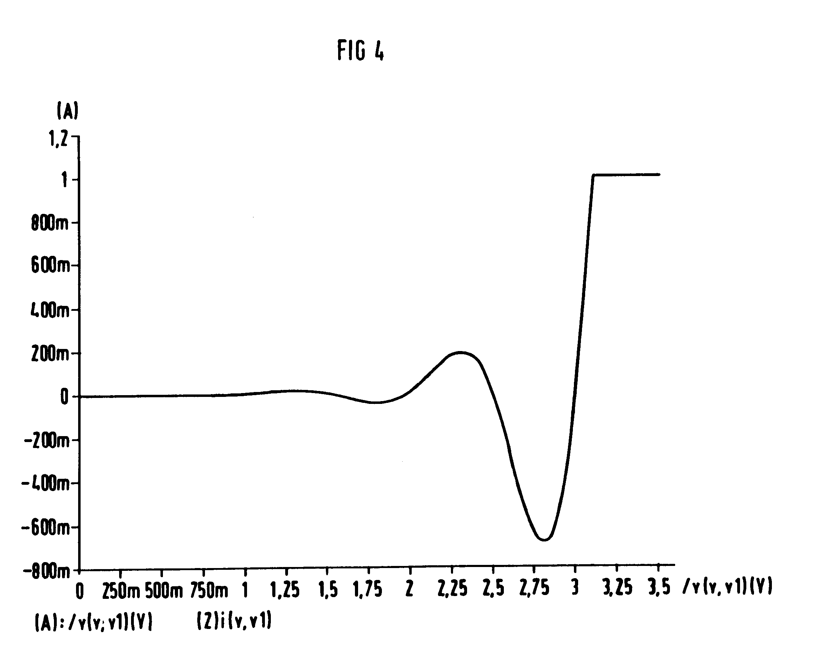

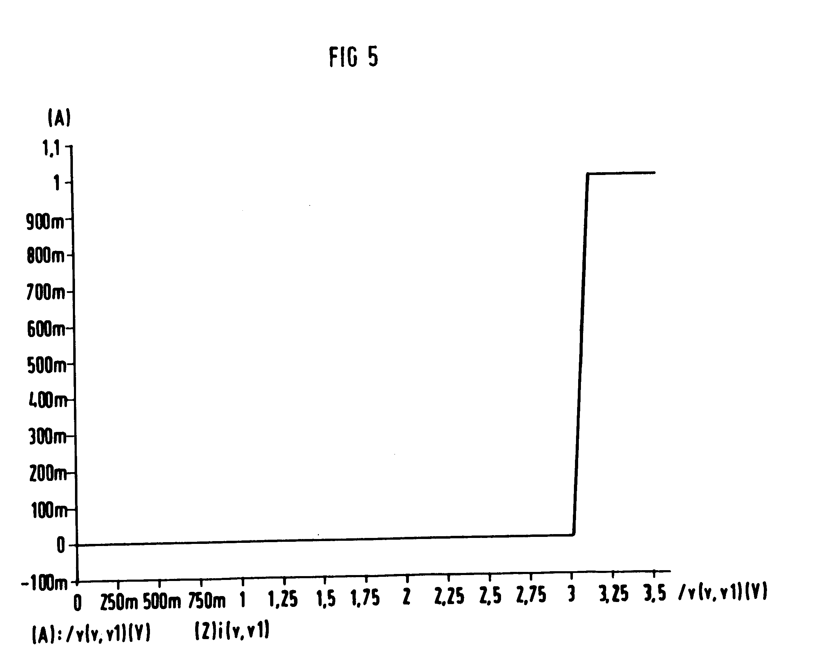

Zur Verdeutlichung des Einflusses von explizit vorgegebenen nicht-differenzierbaren beziehungsweise Extremalpunkten wurde das Verfahren mit und ohne deren explizite Vorgabe durchgeführt. Tabelle 2 zeigt zunächst wieder eine Liste von Datenpunkten, wie sie als Eingabe dienten. Das Maximum liegt bei einer Spannung von 1 Volt. Figur 2 zeigt die Simulation ohne vorgegebenen Maximalpunkt. Man erkennt deutlich die Verschiebung des Maximums um ca. 0.1 Volt hin zu höheren Werten. Das Ergebnis der Modellierung mit vorgegebenem Extremalpunkt, ist in Figur 3 zu sehen: Die Funktionskurve nimmt ihr Maximum jetzt genau bei dem definierten Wert von 1 Volt an. Die Auswirkung von nicht-differenzierbaren Punkten ist in den Figuren 4 und 5 dargestellt: In Figur 4 erkennt man das unerwünschte "Schwingen" des Splines, wenn die "Durchbruchsspannung" bei 3 Volt nicht als nicht-differenzierbarer Punkt kenntlich gemacht wird. Das Problem wird, wie man in Figur 5 sieht, durch die explizite Vorgabe solcher Punkte vollständig behoben.

Die den Funktionskurven, welche in den Figuren dargestellt sind, zugrundeliegenden Wertpaare befinden sich in den gleich bezeichneten Tabellen.

In Figur 1 ist das Ergebnis der Simulation einer Diode F452 mit dem erfindungsgemäßen Verfahren dargestellt. (Strom-Spannungs-Charakteristik). Dieser Simulation liegen die Wertepaare aus Tabelle 1 zugrunde. Sie werden für das erfindungsgemäße Verfahren vereinfacht dargestellt. Zunächst wird mit "scale le-3" die Darstellung der Wertepaare in Exponentialform vereinbart. Ein Punkt wird mit der Bezeichnung point gekennzeichnet. Es folgt das Wertepaar horizontal in den nächsten beiden Spalten. Anschließend ist eine Kennzeichnung angegeben, die dem erfindungsgemäßen Verfahren mitteilt, ob bei der Berechnung dieses Punktes besondere Charakteristika zu beachten sind. -s bedeutet einen normalen Datenpunkt, -d bedeutet einen nicht differenzierbaren Datenpunkt, -e bedeutet einen Extremalwert.

Deutlich kann man am Ergebnis der Simulation erkennen, daß der Extremwert E bei einer Spannung von 8 Volt, sowie der nicht differenzierbare Punkt D (Knick) bei der Spannung 130 Volt vom erfindungsgemäßen Verfahren korrekt wiedergegeben werden.

In Figur 2 ist das Simulationsergebnis eines Bauteils dargestellt, das am Punkt 1 und 2,6 ein Maximum M nicht überschreiten darf. Dem simulierten Ergebnis liegen die in der Tabelle 2 dargestellten Wertepaare zugrunde. Wie man deutlich erkennen kann, ist der Punkt E2 , der in den Wertepaaren als Maximum vorgesehen ist, zwar im Simulationsergebnis Bestandteil der Funktionskurve, aber er ist nicht das Maximum. Bei der hier durchgeführten Simulation wurde in der Definition der Wertepaare das im erfindungsgemäßen Verfahren vorgesehene Kriterium für Extremalwerte "-e" nicht eingesetzt. Dies äußert sich in einer Verschiebung des Maximums im dargestellten Kurvenverlauf.

Figur 3 zeigt den Kurvenverlauf wie er sich nach der Simulation mit dem erfindungsgemäßen Verfahren ergibt, dem dieselbe Eingangswertepaarschar zugrundeliegt, wie bei Figur 2, mit Ausnahme, daß der Punkt 1 und 2,6 in Tabelle 3 als Extremwert mit "-e" gekennzeichnet ist. Hier kann man deutlich erkennen, daß sich der Extremalwert E3 gegenüber der in Figur 2 dargestellten Version verschoben hat und sich nun annähernd an der richtigen Stelle befindet.

In Figur 4 ist ein Bauteil mit dem erfindungsgemäßen Verfahren simuliert, dessen charakteristische Eigenschaften in Wertepaartabelle 4 dargestellt werden. Kennzeichnend für dieses Bauteil ist, daß seine Funktionskurve bei einer Spannung von 3 Volt einen nicht differenzierbaren Punkt (Knick) aufweist. Für die Simulation wurde dieser Punkt nicht durch eine Option "-d" in der Tabelle 4 explizit kenntlich gemacht. Das Ergebnis der Simulation zeigt deutlich, daß das Bauteil während der Simulation zum Schwingen neigt und daß der Kurvenverlauf, der das Bauteil charakterisiert, durch die Simulation nicht korrekt dargestellt wird.

Figur 5 zeigt das Ergebnis einer Simulation mit dem erfindungsgemäßen Verfahren, welcher die Wertepaare aus der Tabelle 5 zugrundeliegen. Tabelle 5 unterscheidet sich durch Tabelle 4, die in Figur 4 simuliert wurde, nur dadurch, daß der Punkt bei 3 Volt nun mit der Option "-d" als nicht differenzierbar gekennzeichnet wurde. Deutlich kann man erkennen, daß die Simulation mit dem erfindungsgemäßen Verfahren nun zu einem korrekten Ergebnis führt, welches charakteristische Eigenschaften des Bauteils beschreibt. Das heißt, der Knick bei einer Spannung von 3 Volt wird korrekt wiedergegeben.

Tabelle 1:

scale 1e-3

| point | -0.9 | -881. | -s |
|-------|------|-------|-----|
| point | -0.6 | -302. | -s |
| point | -0.5 | -149. | -s |
| point | -0.4 | -46. | -s |
| point | -0.3 | -8.18 | -s |
| point | -0.2 | -1.1 | -s |
| point | -0.1 | -0.138 | -s |
| point | 0. | 0. | -d |
| point | 0.5 | 0.6 | -s |
| point | 0.7 | 0.9 | -s |
| point | 1. | 1.3 | -s |
| point | 1.5 | 2. | -s |
| point | 2. | 2.5 | -s |
| point | 3. | 3.3 | -s |
| point | 4. | 3.8 | -s |
| point | 5. | 4.2 | -s |
| point | 7. | 4.38 | -s |
| point | 8. | 4.4 | -e |
| point | 8.1 | 4.4 | -s |
| point | 10. | 4.39 | -s |
| point | 130. | 2.5 | -d |
| point | 131. | 1000. | -s |

Tabelle 2

scale 1e-3

| point | 0. | 0. | -s |
|-------|------|------|-----|
| point | 0.5 | 1.2 | -s |
| point | 0.7 | 1.8 | -s |
| point | 1. | 2.6 | -s |
| point | 1.5 | 2.0 | -s |
| point | 2. | 0.8 | -s |
| point | 3. | 0.0 | -s |

Tabelle 3

scale 1e-3

| point | 0. | 0. | -s |
| point | 0.5 | 1.2 | -s |
| point | 0.7 | 1.8 | -s |
| point | 1. | 2.6 | -e |
| point | 1.5 | 2.0 | -s |
| point | 2. | 0.8 | -s |
| point | 3. | 0.0 | -s |

Tabelle 4

scale 1e-3

| point | 0. | 0. | -s |
| point | 0.5 | 0.1 | -s |
| point | 1.0 | 0.2 | -s |
| point | 1.5 | 0.4 | -s |
| point | 2. | 0.6 | -s |
| point | 2.5 | 0.9 | -s |
| point | 3. | 1.2 | -s |
| point | 3.1 | 1000.0 | -s |

Tabelle 5

scale 1e-3

| point | 0. | 0. | -s |
| point | 0.5 | 0.1 | -s |
| point | 1.0 | 0.2 | -s |
| point | 1.5 | 0.4 | -s |
| point | 2. | 0.6 | -s |
| point | 2.5 | 0.9 | -s |
| point | 3. | 1.2 | -d |
| point | 3.1 | 1000.0 | -s |

**Literaturverzeichnis**

[1] H. Spiro: Simulation integrierter Schaltungen durch universelle Rechnerprogramme, R. Oldenbourg Verlag GmbH, München, 1985.

[2] H. Wiedemann (Racal-Redac-Design-System-GmbH): Übergeordnete Aspekte beim ASIC-Entwurf, in: Tagungsband SMT/ASIC/Hybrid '91, 5. Internationale Fachmesse und Kongress, VDE-Verlag, Berlin, 1991.

[3] H. Stump (Logic Modeling Systems Incorporated): Trends in Technology and EDA for the 1990s, in: Conference Record Electro/90, Ventura, USA, 1990.

B. Tuck: What Do Digital Designers Need to Master the Art of Analog Design, in: Comput. Des. 30 11, 1991.

**Patentansprüche**

1. Verfahren zur Simulation wenigstens eines Bauelementes dessen kennzeichnende Merkmale durch eine Menge von Wertepaaren (A, V) beschrieben werden, mit Hilfe eines Simulators auf einem Rechner, bei dem

a) in einem ersten Schritt durch Spline-Interpolation für alle Wertepaare (A, V) eine Funktion (s) gefunden wird, welche jeweils dem einen Wert (A, V) eines jeweiligen Wertepaares den anderen Wert (V, A) des Wertepaares zuordnet,

b) in einem zweiten Schritt die gefundene Funktion im Simulator verwendet wird, um für das Bauelement beliebige Wertepaare (A, V) zu ermitteln, dadurch gekennzeichnet, daß

c) ein nicht differenzierbarer Punkt (D) im Verlauf der Funktion dadurch erzeugt wird, daß die Menge der Wertepaare in zwei Teilmengen unterteilt wird, in denen der Punkt enthalten ist,

d) die Spline-Interpolation für jede Teilmenge durchgeführt wird, wobei der Punkt einmal als obere Intervallgrenze und das andere Mal als untere Intervallgrenze bezogen auf die 2 Teilmengen für die Spline-Interpolation verwendet wird.

2. Verfahren zur Simulation wenigstens eines Bauelementes nach Anspruch 1, bei dem

a) für die Spline-Interpolation eine kubische Splinefunktion der Form:

$$s(x) = a_{i,3} \cdot (x - x_i)^3 + a_{i,2} \cdot (x - x_i)^2 + a_{i,1} \cdot (x - x_i) + a_{i,0}$$

verwendet wird mit Wertepaaren

$$(x_i, y_i), \ i = 1, \ldots, n \ \text{mit} \ n \in N$$

die dem Betrag von $x_i$ nach in aufsteigender Reihenfolge sortiert sind und die Intervallgrenzen der Teilintervalle für die Spline-Interpolation bilden,

b) die Koeffizienten

$$a_{i,3}, a_{i,2}, a_{i,1}, a_{i,0}$$

für jedes Teilintervall zu:

$$a_{i,0} = y_i$$
$$a_{i,1} = s'(x_i)$$
$$a_{i,2} = \frac{1}{2} \cdot s''(x_i)$$
$$a_{i,3} = \frac{s''(x_{i+1}) - s''(x_i)}{6 \cdot (x_{i+1} - x_i)}$$

bestimmt werden mit den Rekursionsformeln

$$s'(x_{i+1}) = 3 \cdot \Delta^i - \frac{1}{2} s''(x_i) \cdot \Delta_x^i - 2 \cdot s'(x_i)$$

$$s''(x_{i+1}) = 6 \frac{\Delta^i}{\Delta_x^i} - 2 \cdot s''(x_i) - 6 \frac{s'(x_i)}{\Delta_x^i}$$

$$\Delta_x^i := x_{i+1} - x_i$$

$$\Delta_y^i := y_{i+1} - y_i$$

$$\Delta^i := \frac{\Delta_y^i}{\Delta_x^i}$$

unter Verwendung von

$$s'(x_i) = c_i \cdot s'(x_1) + e_i$$

$$s''(x_i) = \check{c}_i \cdot s'(x_1) + \check{e}_i$$

$$c_{i+1} = -\frac{1}{2} \Delta_x^i \cdot \check{c}_i - 2 \cdot c_i$$

$$e_{i+1} = 3 \cdot \Delta^i - \frac{1}{2} \Delta_x^i \cdot \check{e}_i - 2 \cdot e_i$$

$$\check{c}_{i+1} = -2 \cdot \check{c}_i - 6\frac{c_i}{\Delta_x^i}$$

$$\check{e}_{i+1} = 6\frac{\Delta^i}{\Delta_x^i} - 2 \cdot \check{e}_i - 6\frac{e_i}{\Delta_x^i}$$

den Anfangsbedingungen für natürliche Splines

$$c_1 = 1$$
$$e_1 = 0$$
$$\check{c}_1 = 0$$
$$\check{e}_1 = s''(x_1) = 0$$

sowie der Randbedingungen für natürliche Splines

$$s''(x_1) = 0 \text{ und } s''(x_n) = 0$$

und der daraus bestimmten Ableitung

$$s'(x_1) = -\frac{\check{e}_n}{\check{c}_n}$$

Index "'" bedeutet 1. Ableitung
Index "''" bedeutet 2. Ableitung

3. Verfahren nach Anspruch 2, bei dem der Funktion Extremalpunkte (E) vorgegeben werden, indem die Koeffizienten a mit denselben Rekursionsformeln auf folgende Weise bestimmt werden:

a) für $x_1$ als Extremalpunkt unter Verwendung von:

$$s'(x_i) = c_i \cdot s''(x_1) + e_i$$
$$s''(x_i) = \check{c}_i \cdot s''(x_1) + \check{e}_i$$

sowie den Extremwertbedingungen

$$s'(x_1) = 0 \text{ und } s''(x_n) = 0$$

und den Anfangsbedingungen

$$c_1 = 0$$
$$e_1 = s'(x_1) = 0$$
$$\check{c}_1 = 1$$
$$\check{e}_1 = 0$$

und der daraus bestimmten 2. Ableitung

$$s''(x_1) = -\frac{\check{e}_n}{\check{c}_n}$$

b) für $x_n$ als Extremalpunkt unter Verwendung von:,

$$s'(x_n) = c_n \cdot s'(x_1) + e_n$$

sowie den Extremwertbedingungen:

$$s''(x_1) = 0 \text{ und } s'(x_n) = 0$$

und der daraus bestimmten Ableitung

$$s'(x_1) = -\frac{e_n}{c_n}$$

c) für $x_1$ und $x_n$ als Extremalpunkte unter Verwendung von

$$s'(x_n) = c_n \cdot s''(x_1) + e_n$$

sowie den Extremwertbedingungen

$$s'(x_1) = 0 \text{ und } s'(x_n) = 0$$

den Anfangsbedingungen

$$c_1 = 0$$
$$e_1 = s'(x_1) = 0$$
$$\check{c}_1 = 1$$
$$\check{e}_1 = 0$$

und der daraus bestimmten 2. Ableitung

$$s''(x_1) = -\frac{e_n}{c_n}$$

## Claims

1. Method for simulating at least one component, whose characterizing features are described by a set of pairs of values (A, V) by means of a simulator on a computer in which

   a) in a first step, a function (s) is found by spline interpolation for all pairs of values (A, V) which function allocates in each instance to the one value (A, V) of each respective pair of values the other value (V, A) of the pair of values,

   b) in a second step, the function found is used in the simulator to determine arbitrarily selectable pairs of values (A, V) for the component, characterized in that

   c) a non-differentiable point (D) in the progression of the function is generated in that the set of pairs of values is subdivided into two subsets, in which the point is included,

   d) the spline interpolation is carried out for each subset, the point being used on one occasion as upper interval bound and on the other occasion as lower interval bound related to the 2 subsets for the spline interpolation.

2. Method for simulating at least one component according to Claim 1, in which

   a) for the spline interpolation a cubic spline function of the form:

   $$s(x) = a_{i,3} \cdot (x - x_i)^3 + a_{i,2} \cdot (x - x_i)^2 + a_{i,1} \cdot (x - x_i) + a_{i,0}$$

   is used, with pairs of values

   $$(x_i, y_i), \, i = 1, \ldots, n \text{ where } n \in N$$

   which are sorted in ascending sequence according to the absolute value of $x_i$ and form the interval bounds of the partial intervals for the spline interpolation,

   b) the coefficients

   $$a_{i,3}, \, a_{i,2}, \, a_{i,1}, \, a_{i,0}$$

   for each partial interval are determined as:

   $$a_{i,0} = y_i$$
   $$a_{i,1} = s'(x_i)$$
   $$a_{i,2} = \tfrac{1}{2} \cdot s''(x_i)$$
   $$a_{i,3} = \frac{s''(x_{i+1}) - s''(x_i)}{6 \cdot (x_{i+1} - x_i)}$$

   with the recursion formulae

   $$s'(x_{i+1}) = 3 \cdot \Delta^i - \tfrac{1}{2} s''(x_i) \cdot \Delta^i_x - 2 \cdot s'(x_i)$$

   $$s''(x_{i+1}) = 6 \frac{\Delta^i}{\Delta^i_x} - 2 \cdot s''(x_i) - 6 \frac{s'(x_i)}{\Delta^i_x}$$

   $$\Delta^i_x := x_{i+1} - x_i$$
   $$\Delta^i_y := y_{i+1} - y_i$$
   $$\Delta^i := \frac{\Delta^i_y}{\Delta^i_x}$$

   with the use of

   $$s'(x_i) = c_i \cdot s'(x_1) + e_i$$

   $$s''(x_i) = \check{c}_i \cdot s'(x_1) + \check{e}_i$$

$$c_{i+1} = -\tfrac{1}{2}\Delta_x^i \cdot \check{c}_i - 2 \cdot c_i$$

$$e_{i+1} = 3 \cdot \Delta^i - \tfrac{1}{2}\Delta_x^i \cdot \check{e}_i - 2 \cdot e_i$$

$$\check{c}_{i+1} = -2 \cdot \check{c}_i - 6\,\frac{c_i}{\Delta_x^i}$$

$$\check{e}_{i+1} = 6\,\frac{\Delta^i}{\Delta_x^i} - 2 \cdot \check{e}_i - 6\,\frac{e_i}{\Delta_x^i}$$

the initial conditions for natural splines

$$c_1 = 1$$
$$e_1 = 0$$
$$\check{c}_1 = 0$$
$$\check{e}_1 = s''(x_1) = 0$$

as well as the boundary conditions for natural splines

$$s''(x_1) = 0 \text{ and } s''(x_n) = 0$$

and the derivative determined therefrom

$$s'(x_1) = -\frac{\check{e}_n}{\check{c}_n}$$

Index "'" signifies 1st derivative
Index "''" signifies 2nd derivative

3. Method according to Claim 2, in which extreme points (E) are prescribed for the function, in that the coefficients a are determined using the same recursion formulae in the following manner:
   a) for $x_1$ as extreme point with the use of:

$$s'(x_i) = c_i \cdot s''(x_1) + e_i$$

$$s''(x_i) = \check{c}_i \cdot s''(x_1) + \check{e}_i$$

as well as the extreme value conditions

$$s'(x_1) = 0 \text{ and } s''(x_n) = 0$$

and the initial conditions

$$c_1 = 0$$
$$e_1 = s'(x_1) = 0$$
$$\check{c}_1 = 1$$
$$\check{e}_1 = 0$$

and the 2nd derivative determined therefrom

$$s''(x_1) = -\frac{\check{e}_n}{\check{c}_n}$$

b) for $x_n$ as extreme point, with the use of:

$$s'(x_n) = c_n \cdot s'(x_1) + e_n$$

as well as the extreme value conditions:

$$s''(x_1) = 0 \text{ and } s'(x_n) = 0$$

and the derivative determined therefrom

$$s''(x_1) = -\frac{e_n}{c_n}$$

c) for $x_1$ and $x_n$ as extreme points, with the use of

$$s'(x_n) = c_n \cdot s''(x_1) + e_n$$

as well as the extreme value conditions

$$s'(x_1) = 0 \text{ and } s'(x_n) = 0$$

the initial conditions

$$c_1 = 0$$
$$e_1 = s'(x_1) = 0$$
$$\check{c}_1 = 1$$
$$\check{e}_1 = 0$$

and the 2nd derivative determined therefrom

$$s''(x_1) = -\frac{e_n}{c_n}$$

**Revendications**

1. Procédé de simulation d'au moins un composant, dont on décrit les particularités qui le caractérisent par un ensemble de paires (A, V) de valeurs, à l'aide d'un simulateur sur un ordinateur, dans lequel
   a) on trouve dans une première étape par interpolation spline pour toutes les paires (A, V) de valeurs une fonction (s) qui associe à chacune des valeurs (A, V) d'une paire de valeurs l'autre valeur (V, A) de la paire de valeurs,
   b) on utilise dans une seconde étape la fonction trouvée dans le simulateur, pour déterminer pour le composant des paires (A, V) quelconques de valeurs, caractérisé en ce que
   c) on produit un point (D) non différenciable dans la courbe de la fonction en subdivisant l'ensemble des paires de valeurs en deux ensembles partiels, qui contiennent le point,
   d) on effectue l'interpolation spline pour chaque ensemble partiel, on utilise le point une fois comme limite supérieure d'intervalle et l'autre fois comme limite inférieure d'intervalle par rapport aux deux ensembles partiels pour l'interpolation spline.

2. Procédé de simulation d'au moins un composant suivant la revendication 1, dans lequel
   a) on utilise pour l'interpolation spline une fonction spline cubique de la forme :
   $$s(x) = a_{i,3} \cdot (x - x_i)^3 + a_{i,2} \cdot (x - x_i)^2 + a_{i,1} \cdot (x - x_i) + a_{i,0}$$
   ayant les paires de valeurs
   $$(x_i, y_i), \ i = 1,\ldots,n \text{ mit } n \in N$$
   qui sont classées suivant le module de $x_i$ dans l'ordre croissant et qui forment des limites des intervalles partiels pour l'interpolation spline,
   b) on détermine les coefficients
   $$a_{i,3}, a_{i,2}, a_{i,1}, a_{i,0}$$
   pour chaque intervalle par :
   $$a_{i,0} = y_i$$
   $$a_{i,1} = s'(x_i)$$
   $$a_{i,2} = \frac{1}{2} \cdot s''(x_i)$$
   $$a_{i,3} = \frac{s''(x_{i+1}) - s''(x_i)}{6 \cdot (x_{i+1} - x_i)}$$
   avec les formules récursives
   $$s'(x_{i+1}) = 3 \cdot \Delta^i - \frac{1}{2} s''(x_i) \cdot \Delta^i_x - 2 \cdot s'(x_i)$$
   $$s''(x_{i+1}) = 6 \frac{\Delta^i}{\Delta^i_x} - 2 \cdot s''(x_i) - 6 \frac{s'(x_i)}{\Delta^i_x}$$

$$\Delta_x^i := x_{i+1} - x_i$$

$$\Delta_y^i := y_{i+1} - y_i$$

$$\Delta^i := \frac{\Delta_y^i}{\Delta_x^i}$$

en utilisant

$$s'(x_i) = c_i \cdot s'(x_1) + e_i$$

$$s''(x_i) = \breve{c}_i \cdot s'(x_1) + \breve{e}_i$$

$$c_{i+1} = -\frac{1}{2}\Delta_x^i \cdot \breve{c}_i - 2 \cdot c_i$$

$$e_{i+1} = 3 \cdot \Delta^i - \frac{1}{2}\Delta_x^i \cdot \breve{e}_i - 2 \cdot e_i$$

$$\breve{c}_{i+1} = -2 \cdot \breve{c}_i - 6\frac{c_i}{\Delta_x^i}$$

$$\breve{e}_{i+1} = 6\frac{\Delta^i}{\Delta_x^i} - 2 \cdot \breve{e}_i - 6\frac{e_i}{\Delta_x^i}$$

les conditions initiales pour des splines naturelles

$$c_1 = 0$$
$$e_1 = 0$$
$$\breve{c}_1 = 0$$
$$\breve{e}_1 = s''(x_1) = 0$$

ainsi que les conditions aux limites pour des splines naturelles

$$s''(x_1) = 0 \text{ et } s''(x_n) = 0$$

et la dérivée déterminée à partir de ces relations

$$s'(x_1) = -\frac{\breve{e}_n}{\breve{c}_n}$$

le symbole " ′ " signifiant dérivée première
le symbole " ″ " signifiant dérivée seconde.

3. Procédé suivant la revendication 2, dans lequel on prescrit pour la fonction des points (E) extrémaux, en déterminant les coefficients a par les mêmes formules récursives de la manière suivante :

a) en utilisant pour $x_1$ comme point extrémal :

$$s'(x_i) = c_i \cdot s''(x_1) + e_i$$

$$s''(x_i) = \breve{c}_i \cdot s''(x_1) + \breve{e}_i$$

ainsi que les conditions sur les valeurs extrêmes

$$s'(x_1) = 0 \text{ und } s''(x_n) = 0$$

et les conditions initiales

$$c_1 = 0$$
$$e_1 = s'(x_1) = 0$$
$$\breve{c}_1 = 1$$
$$\breve{e}_1 = 0$$

17

et la dérivée seconde déterminée à partir de ces relations

$$s''(x_1) = - \frac{\varepsilon_n}{c_n}$$

b) en utilisant pour $x_n$ comme point extrémal
$$s'(x_n) = c_n \cdot s'(x_1) + e_n$$
ainsi que les conditions sur les valeurs extrêmes
$$s''(x_1) = 0 \text{ et } s'(x_n) = 0$$
et la dérivée qui est déterminée à partir de ces relations
$$s'(x_1) = - \frac{e_n}{c_n}$$
c) en utilisant pour $x_1$ et $x_n$ comme points extrémaux
$$s'(x_n) = c_n \cdot s''(x_1) + e_n$$
ainsi que les conditions sur les valeurs extrêmes
$$s'(x_1) = 0 \text{ und } s'(x_n) = 0$$
les conditions initiales
$$c_1 = 0$$
$$e_1 = s'(x_1) = 0$$
$$c_1 = 1$$
$$\varepsilon_1 = 0$$
et la dérivée seconde qui est déterminée à partir de ces relations
$$s''(x_1) = - \frac{e_n}{c_n}$$

FIG 1

## FIG 2

X1: 1,00121Z
(A) Y1: 2,60149m

(A):/v(v,v1)(V)    (2)i(v,v1)

EP 0 653 081 B1

FIG 3

EP 0 653 081 B1

# FIG 4

(A): /v(v; v1)(V)    (2)i(v, v1)

EP 0 653 081 B1

## FIG 5

**(A)**

(A): /v(v,v1)(V)     (2)i(v,v1)

EP 0 653 081 B1

23